# EUROPEAN PATENT APPLICATION

(11) **EP 3 641 121 A1**
(43) Date of publication of application: **22.04.2020**
(21) Application number: 17909403.2
(22) Date of filing: 08.05.2017
(51) Int. Cl.: H02M 7/04

(54) **COOLING STRUCTURE OF POWER CONVERSION DEVICE**

(71) Applicant: Nissan Motor Co., Ltd., Yokohama-shi, Kanagawa 221-0023 (JP); Renault S.A.S., 92100 Boulogne-Billancourt (FR)
(72) Inventor: ONO, Kimihiro, Atsugi-shi Kanagawa 243-0123 (JP); UMINO, Tomohiro, Atsugi-shi Kanagawa 243-0123 (JP)
(74) Representative: Global IP Europe Patentanwaltskanzlei
(86) International application number: PCT/JP2017/017406
(87) International publication number: WO 2018/207240

(57) **Abstract**

The present invention minimizes an increase in the ambient temperature around a fixing bolt.

A cooling structure of an inverter (1A) has a power module (3), a cooler (5), and a fixing bolt (10). The power module (3) is a power converter. A refrigerant channel (9) is formed in the cooler (5). The fixing bolt (10) secures the power module (3) to the cooler (5) in a state in which the power module (3) and the refrigerant channel (9) are disposed opposite each other. The refrigerant channel (9) has a main pathway (91) disposed opposite the power module (3), and an expanded pathway (92) having a channel that is expanded from the main pathway (91) to a bolt end (10a) of the fixing bolt (10).

## Description

### Technical Field

The present disclosure relates to a cooling structure of a power conversion device.

### Background Technology

In a conventional dynamo-electric machine system, a power module is secured to an inverter case by a bolt. The power module is disposed on a surface opposite fins. A power semiconductor element of the power module dissipates heat to cooling water flowing through a cooling channel via the fins or the like (see, e.g., Patent Document 1).

### Prior Art Documents

### Patent Documents

Patent Document 1: Japanese Laid-Open Patent Application No. 2011 - 182480

### Disclosure of the Invention

### Problems to Be Solved by the Invention

However, it is not disclosed that, in a conventional system, a bolt that secures a power module to an inverter case is cooled. Accordingly, there is room for consideration of the fact that when heat of a power semiconductor element is absorbed by the bolt during driving of the power module, the ambient temperature around the bolt will increase.

The present disclosure was devised in view of the above-mentioned problem, and an object thereof is to suppress an increase in ambient temperature around the fixing bolt.

### Means Used to Solve the Above-Mentioned Problems

In order to achieve the above objective, a cooling structure of a power conversion device of the present disclosure has a power converter, a cooler in which a refrigerant channel is formed, and a fixing bolt that secures the power converter to the cooler with the power converter and the refrigerant channel disposed opposite each other. The refrigerant channel has a main pathway disposed opposite the power converter, and an expanded pathway in which a channel is expanded from the main pathway to a bolt end of the fixing bolt.

### Effect of the Invention

Thus, due to the refrigerant channel having a main pathway disposed opposite the power converter, and an expanded pathway in which the channel is expanded from the main pathway to the bolt end of the fixing bolt, an increase in the ambient temperature around the fixing bolt can be suppressed.

### Brief Description of the Drawings

Figure 1 is a cross-sectional view of an inverter cooling structure of a first embodiment.
Figure 2 is a plan view of a power module in the first to third embodiments.
Figure 3 is a perspective view of a reverse side of a cooler main unit in the first embodiment.
Figure 4 is a perspective view of a boss part in the first embodiment.
Figure 5 is a cross-sectional view of an inverter cooling structure in a second embodiment.
Figure 6 is a perspective view of a reverse side of a cooler main unit in the second embodiment.
Figure 7 is an explanatory drawing for explaining the flow of refrigerant near a bypass pathway in the second embodiment.
Figure 8 is a cross-sectional view of an inverter cooling structure in a third embodiment.
Figure 9 is a perspective view of a reverse side of a cooler main unit in the third embodiment.
Figure 10 is a perspective view of an obverse side of a cooler cover in the third embodiment.
Figure 11 is a cross-sectional view of a modified embodiment of an inverter cooling structure of the present disclosure.
Figure 12 is a perspective view of a reverse side of a cooler main unit in the modified embodiment.
Figure 13A is a perspective view showing a first modified embodiment of a boss part of the present disclosure.
Figure 13B is an explanatory drawing for explaining the flow of refrigerant near the boss part of the first modified embodiment.
Figure 14 is a perspective view showing a second modified embodiment of a boss part of the present disclosure.

### Preferred Embodiments of the Invention

Preferred embodiments for implementing a cooling structure of a power conversion device of the present invention will be described hereinbelow based on the first to third embodiments shown in the drawings.

### First Embodiment

First, the configuration will be described.

The cooling structure in the first embodiment is applied to an inverter device (an example of a power conversion device) of a motor generator mounted in a range-extended electric automobile (an example of an electrically driven vehicle) as a travel drive source or the like. A range-extended electric automobile (EV) has two motor generators and an engine dedicated to power generation. In this range-extended electric automobile, one of the two motor generators are used as a drive (travel) motor generator, and the other is used as a power-generating motor generator. Power is generated by the power-generating motor generator using an engine as a power source. Hereinbelow, the configuration of the first embodiment is described in two sections titled "Inverter Cooling Structure" and "Detailed Description of the Cooler."

### [Inverter Cooling Structure]

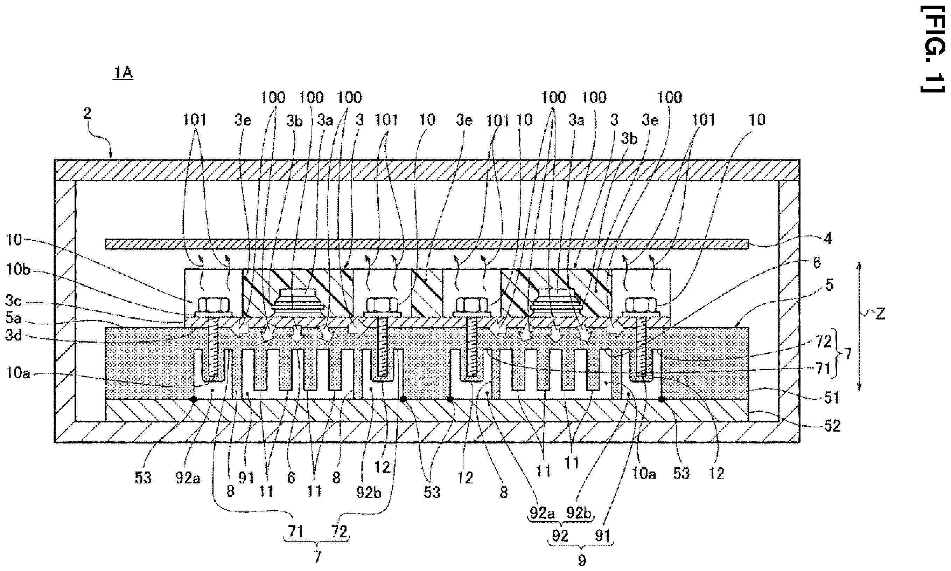

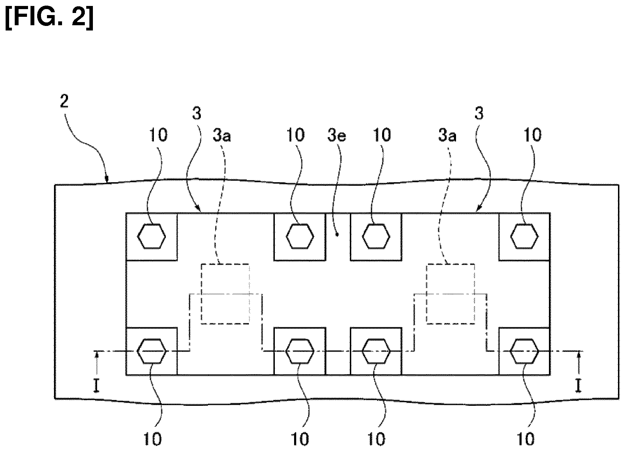

Figure 1 shows a cross-sectional view of an inverter cooling structure in the first embodiment, and Figure 2 shows a plan view of a power module in the first embodiment. Figure 1 is a cross-sectional view along line l-l in Figure 2. Hereinbelow, a detailed configuration of an inverter 1A cooling structure in the first embodiment will be described based on Figures 1 and 2.

The inverter 1A of the first embodiment is provided with an inverter case 2, two power modules 3 (power converters), a drive substrate 4, a cooler 5, a refrigerant channel 9, and fixing bolts 10, as shown in Figures 1 and 2. In the inverter 1A, the power modules 3 and the refrigerant channel 9 are disposed opposite each other, and the power modules 3 and the fixing bolts 10 are cooled by a refrigerant (for embodiment, cooling water) that flows through the refrigerant channel 9.

The power modules 3, the drive substrate 4, the cooler 5, and the like are housed in the inverter case 2, as shown in Figures 1 and 2. The inverter case 2 is secured by, e.g., using screws or the like in a case attachment part that protrudes from an outer peripheral surface of the motor housing of the motor generator (not shown).

Each power module 3 is configured as an integrated module component having a semiconductor element 3a, an insulating wiring board 3b, a heat spreader 3c (heat-dissipating member) for dissipating heat generated when the power module 3 is driven, and an insulating resin 3e. One of the two power modules 3 is electrically connected to a drive motor generator (not shown) and the other is electrically connected to the power-generating motor generator (not shown).

When a power module 3 is manufactured, the semiconductor element 3a, the insulating wiring board 3b, and the heat spreader 3c are stacked and mounted with connections therebetween made using a solder material or the like in the form of a sheet. Thereafter, the insulating resin 3e is formed by transfer molding using an epoxy resin or the like. The two power modules 3 are integrated together by the insulating resin 3e, as shown in Figure 2. The heat spreader 3c, which is a heat-dissipating member, is a rectangular plate larger in size than the insulating resin 3e, and has an outer peripheral portion that protrudes from the outer periphery of the insulating resin 3e. Of the two plate surfaces of the heat spreader 3c, the plate surface on the opposite side of the heat spreader 3c to the plate surface to which the insulating resin 3e is bonded is a heat-dissipating surface 3d in contact with a surface 5a of the cooler 5. In other words, each power module 3 has a structure integrally provided with the heat spreader 3c having the heat-dissipating surface 3d in contact with the surface 5a of the cooler 5. An aluminum alloy material or other highly heat-conductive metal material is used for the material of the heat spreader 3c. Further, a PN bus bar or a UVW bus bar of a high-power system is provided protruding from the power module 3.

Of the surface 5a of the cooler 5, the power modules 3 are fastened and secured to a position of the surface 5a that faces the refrigerant channel 9. In the fastened and secured state of the power module 3, the heat-dissipating surface 3d of the heat spreader 3c in contact with the cooler 5 is in close contact with the surface 5a, as shown in Figure 1.

The drive substrate 4 has electric circuit wiring formed on the surface of or inside an integrated plate comprising an insulator. The drive substrate 4 is, e.g., a multilayer substrate in which a plurality of substrates are stacked. The drive substrate 4 is disposed spaced apart from the power module 3.

The cooler 5 is configured from a cooler main unit 51, a cooler cover 52, and a seal member 53. The seal member 53 is disposed between the cooler main unit 51 and the cooler cover 52, and the cooler main unit 51 and the cooler cover 52 are joined together. Moreover, the cooling scheme of the power module 3 is an indirect cooling scheme (indirect water-cooled structure). A detailed configuration of the cooler 5 will be described later.

The fixing bolts 10 secure the power modules 3 to the cooler 51 in a state in which the power modules 3 and the refrigerant channel 9 are disposed opposite each other. The fixing bolts 10 are inserted through a through-hole formed in the outer peripheral part of the heat spreader 3c and is fastened to a boss part 12 formed on the cooler main unit 51. The fixing bolts 10 are inserted through a washer 10b prior to being inserted into a through-hole. Further, when one power module 3 is secured to the cooler main unit 51, a plurality of locations (e.g., four locations) are secured by the fixing bolts 10, as shown in Figure 2. A heat-conducting metal material is used for the material of the fixing bolts 10. Internal threading is formed at the inner periphery of the boss part 12.

### [Detailed Configuration of the Cooler]

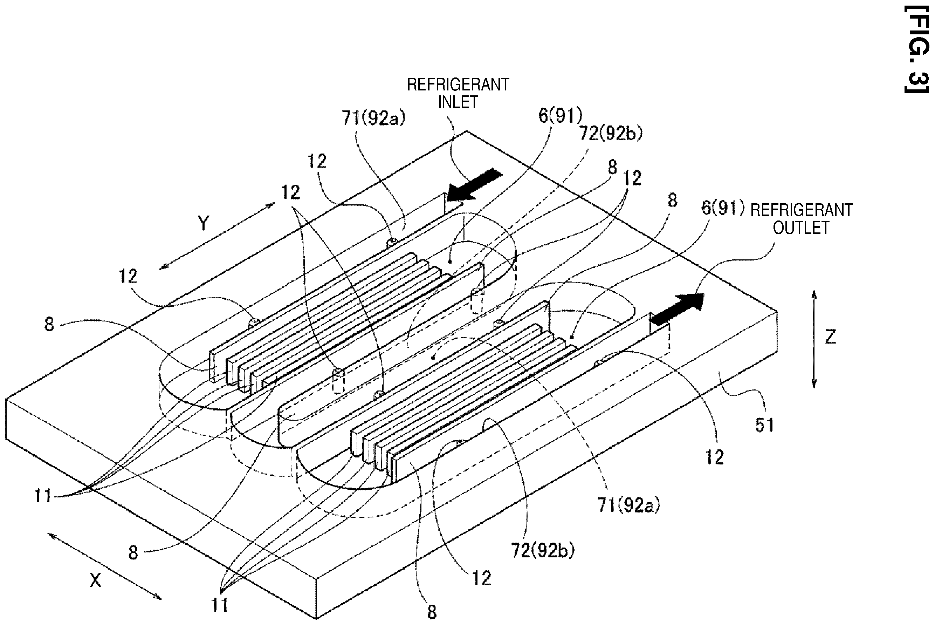

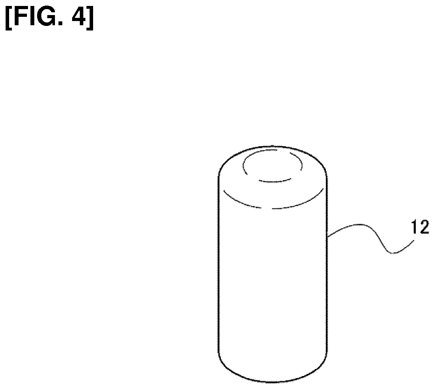

Figure 3 shows a perspective view of a reverse surface side of a cooler main unit in the first embodiment. Figure 4 shows a perspective view of a boss part in the first embodiment. The reverse surface side of a cooler main body is a surface side of the cooler cover in Figure 3. Hereinbelow, the configuration of the cooler will be described in detail in the first embodiment with reference to Figures 1, 3, and 4.

Two main pathway grooves 6, two expanded pathway grooves 7 (first expanded pathway grooves), and partitions 8 are formed in the cooler main unit 51. The expanded pathway grooves 7 each comprise an inlet-side expanded pathway groove 71 and an outlet-side expanded pathway groove 72. In the X direction, the grooves are disposed in the following sequence: the inlet-side expanded pathway groove 71, the main pathway groove 6, the outlet-side expanded pathway groove 72, the inlet-side expanded pathway groove 71, the main pathway groove 6, and the outlet-side expanded pathway groove 72, as shown in Figure 3.

The main pathway grooves 6 are sandwiched between the inlet-side expanded pathway grooves 71 and the outlet-side expanded pathway grooves 72. The main pathway grooves 6 are disposed in a position adjacent to the inlet-side expanded pathway grooves 71 and the outlet-side expanded pathway grooves 72 with the partitions 8 interposed therebetween. The outlet-side expanded pathway groove 72 and the inlet-side expanded pathway groove 71 disposed between the two main pathway grooves 6 are disposed in adjacent positions with the partitions 8 interposed therebetween. Further, any two grooves that are adjacent to one another are in communication with each other at some part thereof. In other words, the grooves are in communication with each other, and the grooves overall are in communication so as to constitute a single groove. A height (depth, Z direction) of the expanded pathway grooves 7 are the same as a height (depth, Z direction) of the main pathway grooves 6. In other words, the height of the inlet-side expanded pathway grooves 71 and the outlet-side expanded pathway grooves 72 is the same as the height of the main pathway grooves 6. That is to say, the inlet-side expanded pathway grooves 71 and the outlet-side expanded pathway grooves 72 are expanded across the entirety of the main pathway groove 6 in the height direction.

The inlet-side expanded pathway grooves 71 which is not disposed between the two main pathway grooves 6 is in communication with a refrigerant inlet path (not shown) through which refrigerant flow into the cooler 5 from the outside (see arrow). The inlet-side expanded pathway grooves 71 and the refrigerant inlet path are in communication on the side of the inlet-side expanded pathway grooves 71 that are not in communication with the main pathway grooves 6 in the Y direction (lengthwise direction) of the inlet-side expanded pathway grooves 71. The outlet-side expanded pathway grooves 72 that are not disposed between the two main pathway grooves 6 is in communication with a refrigerant outlet path (not shown) that allows refrigerant to flow out from the cooler 5 to the exterior (see arrow). The outlet-side expanded pathway grooves 72 and the refrigerant outlet path are in communication on the side of the outlet-side expanded pathway grooves 72 that are not in communication with the main pathway grooves 6 in the Y direction of the outlet-side expanded pathway groove 72.

A plurality of (e.g., four) fins 11 is formed in the main pathway groove 6, as shown in Figure 3. The fins 11 are rectangular and extend in the Y direction of the main pathway grooves 6. The fins 11 are disposed at equidistant intervals in the X direction (crosswise direction) of the main pathway groove 6. Also, the height (Z direction) of the fins 11 is less than the height of the main pathway groove 6, as shown in Figure 1.

A plurality of (e.g., two) boss parts 12 to which the fixing bolts 10 are fastened is formed in each of the inlet-side expanded pathway grooves 71 and the outlet-side expanded pathway grooves 72, as shown in Figure 3. An edge of the boss parts 12 is formed in a filleted shape, as shown in Figure 4. The edge of the boss parts 12 is a distal end portion of the boss part 12 protruding toward the reverse surface side of the cooler main unit 51, and is a portion in which a bolt end 10a of the fixing bolts 10 is positioned when the fixing bolts 10 have been secured to the boss parts 12. Also, the height (Z direction) of the boss part 12 is less than the height of the inlet-side expanded pathway groove 71 and the outlet-side expanded pathway groove 72, as shown in Figure 1.

When the cooler main unit 51 and the cooler cover 52 are joined together, a refrigerant channel 9 is formed between the cooler main unit 51 and the cooler cover 52, as shown in Figure 1. In other words, main pathways 91 and expanded pathways 92 (first expanded pathways) are formed as the refrigerant channel 9.

The main pathways 91 are formed by the main pathway grooves 6 and the cooler cover 52. The expanded pathways 92 are configured by inlet-side expanded pathways 92a and an outlet-side expanded pathway 92b. The inlet-side expanded pathways 92a are formed by the inlet-side expanded pathway grooves 71 and the cooler cover 52. The outlet-side expanded pathways 92b are formed by the outlet-side expanded pathway grooves 72 and the cooler cover 52. Accordingly, the refrigerant channel 9 has the main pathways 91, the inlet-side expanded pathways 92a, and the outlet-side expanded pathways 92b.

When the power modules 3 are secured to the cooler main unit 51, the main pathways 91 are disposed opposite the power modules 3. Also, the expanded pathways 92 are pathways in which the channel has been expanded from the main pathways 91 to the bolt ends 10a of the fixing bolts 10.

Next, the effect will be described. The effect of the cooling structure of the inverter 1A of the first embodiment will be described in sections titled "Effect of refrigerant flow," "Mechanism by which ambient temperature increases around the bolt," "Basic effect of the inverter cooling structure," and "Characteristic effect of the inverter cooling structure."

### [Effect of Refrigerant Flow]

Hereinbelow, the flow of refrigerant will be described with reference to Figures 1 and 3. A configuration in which the cooler cover 52 has been attached to the cooler main unit 51 of Figure 3 will be described. Accordingly, because the main pathway grooves 6 serve as the main pathways 91, the inlet-side expanded pathway grooves 71 serve as the inlet-side expanded pathways 92a, and the outlet-side expanded pathway grooves 72 serve as the outlet-side expanded pathways 92b, the symbol for the respective pathway will be noted in parentheses following these symbols in Figure 3.

Refrigerant flows from the exterior into the refrigerant inlet path. Next, the refrigerant that has flowed in from the refrigerant inlet path flows into one end of an inlet-side expanded pathway 92a (see arrow). Next, the refrigerant that has flowed into the inlet-side expanded pathway 92a flows from this inlet-side expanded pathway 92a to main pathways 91. In other words, the inlet-side expanded pathway 92a allows the refrigerant flowing through the refrigerant channel 9 to flow into the main pathways 91. When this occurs, the entire boss parts 12 disposed in the inlet-side expanded pathway 92a are covered by the refrigerant flowing through the inlet-side expanded pathway 92a. Accordingly, the boss parts 12 are cooled and the bolt end 10a of the fixing bolts 10 secured to the boss parts 12 is cooled. The fixing bolts 10 are thereby cooled.

Next, the refrigerant that has flowed into the main pathways 91 flows out from the main pathways 91 to an outlet-side expanded pathway 92b. In other words, refrigerant flows out from the main pathway 91 into the outlet-side expanded pathway 92b. Also, when this occurs, the refrigerant flowing through the main pathways 91 flows between the partitions 8, the fins 11, and the like. Accordingly, the heat emitted by the semiconductor element 3a is dissipated by the fins 11 by heat exchange. In other words, the power modules 3 are cooled.

Next, the refrigerant that has flowed out to the outlet-side expanded pathway 92b flows from the outlet-side expanded pathway 92b to an inlet-side expanded pathway 92a. When this occurs, the entire boss part 12 disposed in the outlet-side expanded pathway 92b is covered by the refrigerant flowing through the outlet-side expanded pathway 92b. Accordingly, the fixing bolts 10 are cooled in the same manner as described above.

Next, the refrigerant that has flowed into the inlet-side expanded pathway 92a flows into the main pathways 91 and flows out from the main pathways 91 to the outlet-side expanded pathway 92b, in the same manner as described above. Accordingly, the power modules 3 and the fixing bolts 10 are cooled by the refrigerant in the same manner as described above. The flow of the refrigerant and the cooling are the same as described above and a description thereof is therefore omitted. The refrigerant that has flowed out to the outlet-side expanded pathway 92b then flows out from the outlet-side expanded pathway 92b to the refrigerant outlet path (see arrow). In other words, the refrigerant flows out to the exterior. Thus, power modules 3 and the fixing bolts 10 are cooled.

### [Mechanism by Which Ambient Temperature Increases Around the Bolt]

Hereinbelow, the Mechanism by which ambient temperature increases around the bolts will be described with reference to Figure 1.

When the power modules 3 are driven, the semiconductor element 3a generates heat. This heat is transmitted from the power modules 3 to the heat spreader 3c. Next, the heat transmitted to the heat spreader 3c is dissipated from the heat-dissipating surface 3d of the heat spreader 3c to the cooler main unit 51 and the fixing bolts 10, as indicated by arrows 100. The fixing bolts 10 are thereby heated by the heat transmitted to the fixing bolts 10. The heat is then emitted from the fixing bolts 10 and the ambient temperature around the fixing bolts 10 increases. For example, the heat is emitted from the head part of the fixing bolts 10, and the ambient temperature between the power modules 3 and the drive substrate 4 increases, as indicated by arrows 101.

Thus, when the heat in the semiconductor element 3a is absorbed by the fixing bolts 10 at the time the power modules 3 are driven, the ambient temperature around the fixing bolts 10 increases.

### [Basic Effect of the Inverter Cooling Structure]

As described above, when the heat in the semiconductor element 3a is absorbed by the fixing bolts 10 at the time the power modules 3 are driven, the ambient temperature around the bolts increases. In response thereto, in the first embodiment, the cooling structure of the inverter 1A is configured having, as the refrigerant channel 9, main pathways 91 disposed opposite the power modules 3, and expanded pathways 92 having a channel that is expanded from the main pathways 91 to the bolt end 10a of the fixing bolts 10. In other words, the bolt end 10a of the fixing bolts 10 is cooled by the refrigerant flowing through the expanded pathways 92, and efficiency of cooling the fixing bolts 10 is increased. Accordingly, an increase in heat in the fixing bolts 10 is minimized even when the fixing bolts 10 absorb the heat in the semiconductor element 3a. As a result, an increase of the ambient temperature around the fixing bolts 10 is suppressed.

In the first embodiment, the boss parts 12 are disposed in the expanded pathways 92. In other words, the boss parts 12 are cooled by the refrigerant flowing through the expanded pathway 92, and the efficiency of cooling the fixing bolts 10 is further increased. Accordingly, an increase in heat in the fixing bolts 10 is further minimized even when the fixing bolts 10 absorb the heat in the semiconductor element 3a. Therefore, an increase of the ambient temperature around the fixing bolts 10 is further suppressed.

In the first embodiment, the main pathway grooves 6 and the expanded pathway grooves 7 are formed in the cooler main unit 51 and/or the cooler cover 52 (the cooler main unit 51 in the first embodiment). When the cooler main unit 51 and the cooler cover 52 are joined together, the main pathway 91 is formed between the cooler main unit 51 and the cooler cover 52 by the main pathway groove 6. Also, when the cooler main unit 51 and the cooler cover 52 are joined together, the expanded pathways 92 are formed between the cooler main unit 51 and the cooler cover 52 by the expanded pathway grooves 7. Therefore, the main pathways 91 and the expanded pathways 92, which serve as the refrigerant channel 9, can be readily formed merely by forming the pathway grooves 6, 7 in the cooler main unit 51 and/or the cooler cover 52.

### [Characteristic Effect of the Inverter Cooling Structure]

In the first embodiment, the main pathway grooves 6, and the expanded pathway grooves 7 in communication with the main pathway grooves 6, are formed in the cooler main unit 51. When the cooler main unit 51 and the cooler cover 52 are joined together, the main pathways 91 are formed by the main pathway grooves 6 and the cooler cover 52. Also, when the cooler main unit 51 and the cooler cover 52 are joined together, the expanded pathways 92 are formed by the expanded pathway grooves 7 and the cooler cover 52. In other words, the main pathways 91 and the expanded pathways 92 serving as the refrigerant channel 9 can be formed by merely forming the pathway grooves 6, 7 in the cooler main unit 51. Accordingly, the pathway grooves 6, 7 do not need to be formed in the cooler cover 52. Therefore, the number of steps for forming the pathway grooves 6, 7 in the cooler cover 52 can be reduced. Additionally, the refrigerant channel 9 is formed by simply placing the cooler cover 52 on the cooler main unit 51.

In the first embodiment, the main pathways 91 and expanded pathways 92 are disposed in adjacent positions with the partitions 8 interposed therebetween. The expanded pathways 92 are a pathway (first expanded pathway) expanded to the inlet-side expanded pathway 92a by which refrigerant flowing through the refrigerant channel 9 flows into the main pathway 91, and to the outlet-side expanded pathway 92b by which the refrigerant flows out from the main pathway 91. In other words, the refrigerant flowing through the inlet-side expanded pathway 92a and the outlet-side expanded pathway 92b are the main stream of refrigerant flowing through the refrigerant channel 9 in the same manner as the main pathways 91. Accordingly, the entire boss parts 12 are covered by the refrigerant, and the efficiency of cooling the fixing bolts 10 is therefore further increased. Accordingly, an increase of heat in the fixing bolt 10 is even more greatly minimized even when the fixing bolts 10 absorb the heat of the semiconductor element 3a. Therefore, an increase of the ambient temperature around the fixing bolts 10 is even more greatly minimized.

In the first embodiment, the edge of the boss parts 12 is formed in a filleted shape. In other words, when the refrigerant flowing through the expanded pathways 92 collides with the boss parts 12, due to the edge of the boss parts 12 being formed in a filleted shape, pressure loss that occurs at the time of collision can be reduced more greatly than when the edge is not formed in a filleted shape. Therefore, pressure loss in the expanded pathways 92 (the inlet-side expanded pathway 92a and outlet-side expanded pathway 92b) can be reduced.

Next, the effect will be described. The following enumerated effects are obtained by the cooling structure of the inverter 1A in the first embodiment.
(1) The cooling structure has a power converter (power module 3), a cooler 5 in which a refrigerant channel 9 is formed, and a fixing bolt 10 that secures the power converter (power module 3) to the cooler 5 with the power converter (power module 3) and the refrigerant channel 9 disposed opposite each other. The cooling structure has, as the refrigerant channel 9, a main pathway 91 disposed opposite the power converter (power module 3), and an expanded pathway 92 having a channel that is expanded from the main pathway 91 to the bolt end 10a of the fixing bolt 10. Accordingly, is it possible to provide a cooling structure for a power conversion device (inverter 1A) with which an increase of the ambient temperature around the fixing bolt 10 is minimized.
(2) A boss part 12 to which the fixing bolt 10 is fastened is formed in the cooler 5. The boss part 12 is disposed in the expanded pathway 92. Accordingly, in addition to the effect of (1), an increase of the ambient temperature around the fixing bolt 10 can be more greatly minimized.
(3) The cooler 5 is configured from a cooler main unit 51 and a cooler cover. A main pathway groove 6 and an expanded pathway groove 7 are formed in the cooler main unit 51 and/or the cooler cover 52 (the cooler main unit 51 in the first embodiment). When the cooler main unit 51 and the cooler cover 52 are joined together, the main pathway 91 is formed between the cooler main unit 51 and the cooler cover 52 by the main pathway groove 6 and the expanded pathway 92 is formed between the cooler main unit 51 and the cooler cover 52 by the expanded pathway groove 7. Accordingly, in addition to the effects of (1) and (2), the main pathway 91 and the expanded pathway 92 serving as the refrigerant channel 9 can be readily formed merely by forming the pathway grooves 6, 7 in the cooler main unit 51 and/or the cooler cover 52.
(4) The main pathway groove 6 and the expanded pathway groove 7 in communication with the main pathway groove 6 are formed in the cooler main unit 51. When the cooler main unit 51 and the cooler cover 52 are joined together, the main pathway 91 is formed by the main pathway groove 6 and the cooler cover 52, and the expanded pathway 92 is formed by the expanded pathway groove 7 and the cooler cover 52. Accordingly, in addition to the effect of (3), the number of steps for forming the pathway grooves 6, 7 in the cooler cover 52 can be reduced.
(5) The main pathway 91 and the expanded pathway 92 are disposed in adjacent positions with the partitions 8 interposed therebetween. The expanded pathway 92 is a first expanded pathway (expanded pathway 92) expanded to an inlet side (inlet-side expanded pathway 92a) by which refrigerant flowing through the refrigerant channel 9 flows into the main pathway 91, and an outlet side (outlet-side expanded pathway 92b) by which the refrigerant flows out from the main pathway 91. Accordingly, in addition to the effects of (1) to (4), an increase of the ambient temperature around the fixing bolt 10 can be even more greatly minimized.
(6) The edge of the boss part 12 is formed in a filleted shape. Accordingly, in addition to the effects of (2) to (5), pressure loss in the expanded pathway 92 (the inlet-side expanded pathway 92a and the outlet-side expanded pathway 92b) can be reduced.

### Second Embodiment

In the second embodiment, boss parts are disposed in the expanded pathway such that a bypass pathway that bypasses the boss part is formed.

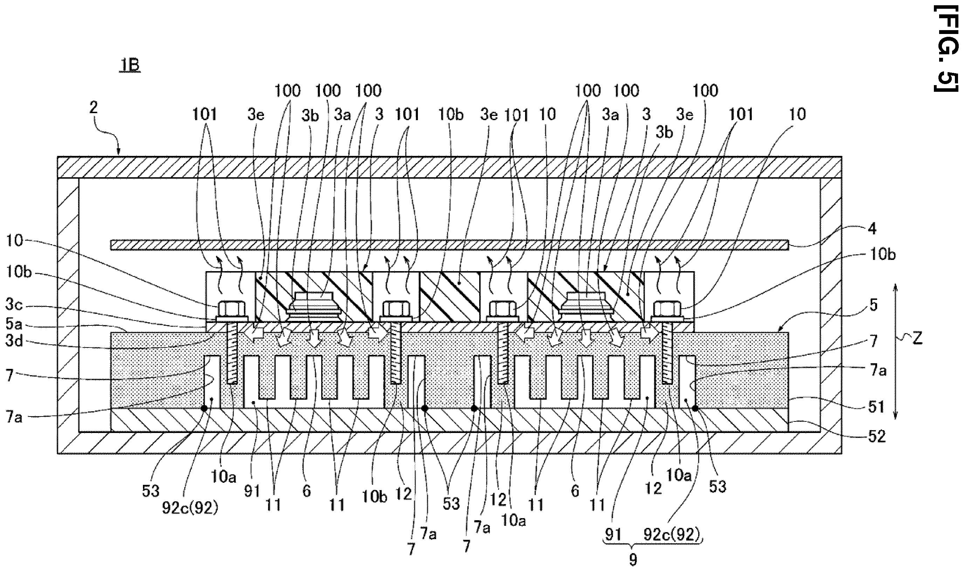

The configuration will be described first. Similarly to the first embodiment, the cooling structure in the second embodiment is applied to an inverter device (an example of a power conversion device) of a motor generator mounted as a travel drive source or the like in a range-extended electric automobile (an example of an electrically driven vehicle). Hereinbelow, a "Detailed Description of the Cooler" of the second embodiment will be described. The "Inverter 1B Cooling Structure" of the second embodiment is similar to the "Inverter Cooling Structure" of the first embodiment, and the corresponding configuration is denoted using the same symbols in Figure 5 and a description thereof is omitted.

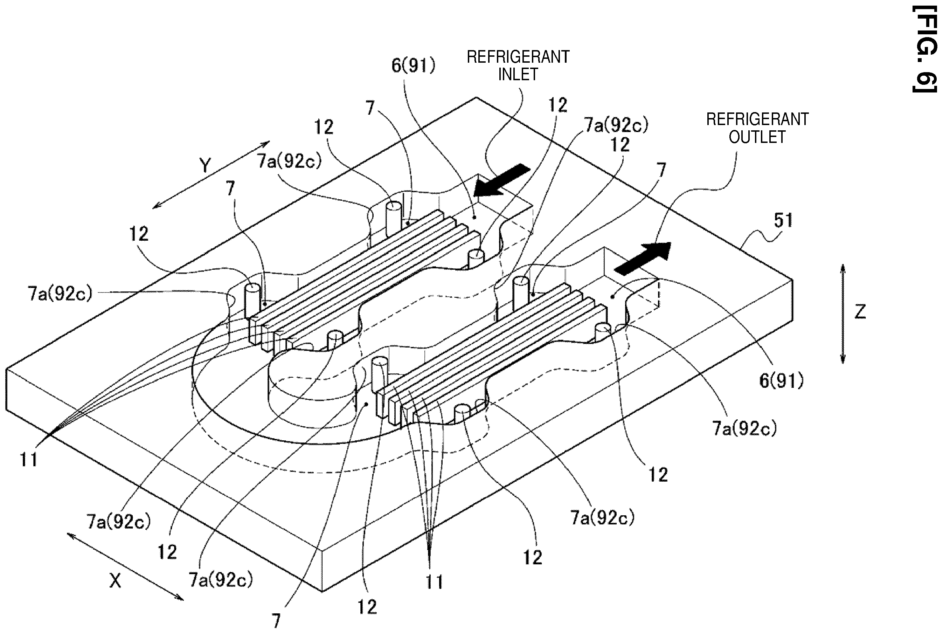

Figure 5 shows a cross-sectional view of the inverter cooling structure in the second embodiment. Figure 6 shows a perspective view of the reverse side of the cooler main unit in the second embodiment. Hereinbelow, the configuration of the cooler will be described in detail in the second embodiment with reference to Figures 5 and 6.

Two main pathway grooves 6 and eight expanded pathway grooves 7 (second expanded pathway grooves) are formed in the cooler main unit 51.

The two main pathway grooves 6 are partially in communication with each other, as shown in Figure 6. In other words, the two main pathway grooves 6 are in communication with each other so as to constitute a single groove. Also, two expanded pathway grooves 7 are formed on each X-direction side of a single main pathway groove 6. In other words, the expanded pathway grooves 7 are grooves to which a portion of the main path groove 6 has been expanded. The height (depth, Z direction) of the expanded pathway grooves 7 is the same as the height (depth, Z direction) of the main pathway groove 6. That is to say, the expanded pathway grooves 7 are expanded across the entirety of the main pathway grooves 6 in the height direction (Z direction).

One main pathway groove 6 is in communication with a refrigerant inlet path (not shown) that allows refrigerant to flow from the exterior into the cooler 5 (see arrow). The other main pathway groove 6 is in communication with a refrigerant outlet path (not shown) that allows refrigerant to flow out from the cooler 5 to the exterior (see arrow).

A plurality of (e.g., four) fins 11 is formed in the main pathway grooves 6, as shown in Figure 6. The fins 11 are rectangular and extend in the Y direction of the main pathway grooves 6. The fins 11 are disposed at equidistant intervals in the X direction of the main pathway grooves 6. The height (Z direction) of the fins 11 is less than the height of the main pathway grooves 6, as shown in Figure 1.

Boss parts 12 to which the fixing bolts 10 are fastened are formed in the expanded pathway grooves 7, as shown in Figure 6. The boss parts 12 are disposed in a position away from a side wall 7a of the expanded pathway grooves 7, as shown in Figure 5. Also, the height (Z direction) of the boss parts 12 is the same as the height of the main pathway grooves 6 and the expanded pathway grooves 7, as shown in Figure 5. The boss parts 12 of the second embodiment are different from the first embodiment and are not formed in a filleted shape.

When the cooler main unit 51 and the cooler cover 52 are joined together, a refrigerant channel 9 is formed between the cooler main unit 51 and the cooler cover 52, as shown in Figure 5. In other words, main pathways 91 and expanded pathways 92 (second expanded pathways) are formed as the refrigerant channel 9.

The main pathways 91 are formed by the main pathway grooves 6 and the cooler cover 52. The expanded pathways 92 are formed by the expanded pathway grooves 7 and the cooler cover 52. In other words, the expanded pathways 92 are a pathway in which a portion of the main pathways 91 has been expanded. Furthermore, bypass pathways 92c are formed by the expanded pathway grooves 7, the boss parts 12, and the cooler cover 52. In other words, the bypass pathways 92c are formed in the expanded pathways 92. Accordingly, the refrigerant channel 9 has the main pathways 91 and the bypass pathways 92c.

When the power modules 3 are secured to the cooler main unit 51, the main pathways 91 are disposed opposite the power module 3. Also, the expanded pathways 92 are pathways in which the channel has been expanded from the main pathways 91 to the bolt end 10a of the fixing bolts 10.

Next, the effect will be described. The increase mechanism of the second embodiment is the same "Mechanism by which ambient temperature increases around the bolt" in the first embodiment. Accordingly, the corresponding configuration is denoted using the same symbols in Figure 5 and a description thereof is omitted. Also, the effect of the second embodiment is the same "Basic effect of the inverter cooling structure" in the first embodiment. The effect in the cooling structure of the inverter 1B of the second embodiment is described hereinbelow in sections titled "Effect of refrigerant flow" and "Characteristic effect of the inverter cooling structure."

### [Effect of Refrigerant Flow]

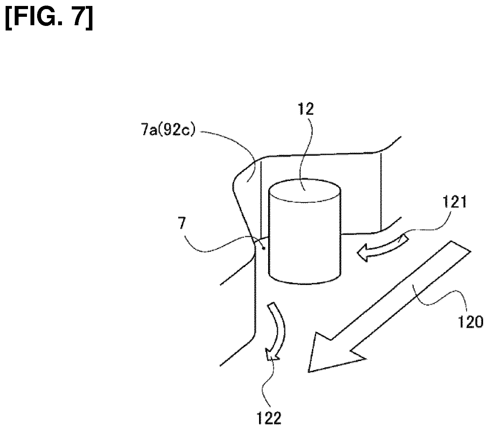

Figure 7 shows the flow of refrigerant in the second embodiment. Hereinbelow, the flow of refrigerant will be described with reference to Figures 5 to 7. A configuration in which the cooler cover 52 has been attached to the cooler main unit 51 of Figure 6 will be described. Accordingly, the main pathway grooves 6 serve as the main pathways 91, and therefore, the symbol for the pathway will be noted in parentheses following the symbol in Figure 6. Also, the space between the side wall 7a and the boss part 12 in the expanded pathway grooves 7 serves as the bypass pathways 92c, and therefore, the symbol for the pathway will be noted in parentheses following the side wall 7a in Figure 6.

Refrigerant flows from the exterior to the refrigerant inlet path. Next, the refrigerant that has flowed in from the refrigerant inlet path flows to one end of one main pathway 91 (see arrow). Next, the refrigerant that has flowed into the one main pathway 91 flows from the one main pathway 91 into the other main pathway 91.

When this occurs, the refrigerant flowing through the one main pathway 91 flows between the fins 11 and the like. Accordingly, heat emitted by the semiconductor element 3a is dissipated by the fins 11 by heat exchange. In other words, the power module 3 is cooled.

Also, when this occurs, some of the refrigerant flowing through the one main pathway 91 flows to the bypass pathway 92c at a midway point, as indicated by arrow 121 in Figure 7. Furthermore, the refrigerant that has flowed into the bypass pathway 92c flows between the side wall 7a of the expanded pathway grooves 7 and the boss parts 12. The refrigerant that has flowed between the side wall 7a and the boss parts 12 then flows into the one main pathway 91, as indicated by arrow 122 in Figure 7. In other words, of the refrigerant flowing through the refrigerant channel 9, the refrigerant flowing through the one main pathway 91 is a main stream (arrow 102 in Figure 7), and the refrigerant flowing through the bypass pathway 92c is a side stream. That is to say, refrigerant is bypassed from the main stream and supplied to the bypass pathway 92c. Accordingly, the refrigerant that flows into the bypass pathway 92c flows around the boss parts 12. The boss parts 12 are thereby cooled and the bolt end 10a of the fixing bolts 10 secured to the boss parts 12 are cooled. Consequently, the fixing bolts 10 are cooled. The other boss parts 12 are also cooled in a similar manner, and therefore the other fixing bolts 10 are cooled as well.

Next, the refrigerant that has flowed into the other main pathway 91 flows out from the other main pathway 91 to the refrigerant outlet path (see arrow). In other words, the refrigerant flows out to the exterior. Also, the refrigerant flowing through the other main pathway 91 flows between the fins 11 and the like in the same manner as the refrigerant flowing through the one main pathway 91. Furthermore, some of the refrigerant flowing through the other main pathway 91 flows into the bypass pathway 92c at a midway point in the same manner as described above (see the arrow 121 in Figure 7). The refrigerant that has flowed to the bypass pathway 92c flows into the other main pathway 91 in the same manner as described above (see the arrow 122 in Figure 7). Accordingly, the power modules 3 and the fixing bolts 10 are cooled by the refrigerant in the same manner as described above. The flow of the refrigerant and the cooling are the same as described above and a description thereof is therefore omitted. The main stream and the side stream are the same as described above, and a description thereof is therefore omitted. Thus, power modules 3 and the fixing bolts 10 are cooled.

### [Characteristic Effect of the Inverter Cooling Structure]

In the second embodiment, the main pathway grooves 6 and the expanded pathway grooves 7 in communication with the main pathway groove 6 are formed in the cooler main unit 51 similarly to the first embodiment. When the cooler main unit 51 and the cooler cover 52 are joined together, the main pathways 91 are formed by the main pathway grooves 6 and the cooler cover 52, and the expanded pathways 92 are formed by the expanded pathway grooves 7 and the cooler cover 52. Therefore, the number of steps for forming the pathway grooves 6, 7 in the cooler cover 52 can be reduced. Additionally, the refrigerant channel 9 is formed by merely placing the cooler cover 52 on the cooler main unit 51.

In the second embodiment, the expanded pathway 92 is a pathway (second expanded pathway) where a part of the main pathway 91 has been expanded. The boss part 12 is disposed in this pathway such that a bypass pathway 92c that bypasses the boss part 12 is formed. In other words, of the refrigerant flowing through the refrigerant channel 9, the refrigerant flowing through the main pathway 91 is the main stream, and the refrigerant flowing through the bypass pathway 92c is the side stream. Accordingly, the boss part 12 is disposed in a position away from the main stream. Pressure loss in the main stream caused by the boss part 12 can thereby be reduced. Also, the boss part 12 is cooled by the refrigerant flowing to the bypass pathway 92c, and the efficiency of cooling the fixing bolt 10 is therefore also increased. Accordingly, an increase in the heat of the fixing bolt 10 is minimized even when the fixing bolt 10 absorbs the heat of the semiconductor element 3a. It is therefore possible to both reduce pressure loss in the main stream caused by the boss part 12 and minimize increase in the ambient temperature around the fixing bolt 10. Additionally, in the second embodiment, the pressure loss in the main stream caused by the boss parts 12 can be reduced more greatly than when the boss parts 12 are disposed in the main stream as in the first embodiment.

Next, the effect will be described. The effects described in (1) to (4) of the first embodiment are obtained by the cooling structure of the inverter 1B in the second embodiment. Also, the effect in (7) below can be obtained by the cooling structure of the inverter 1B in the second embodiment.

(7) The expanded pathway 92 is a second expanded pathway (expanded pathway 92) where a part of the main pathway 91 has been expanded. The boss part 12 is disposed in the second expanded pathway (expanded pathway 92) such that a bypass pathway 92c that bypasses the boss part 12 is formed. Accordingly, in addition to the effects of (2) to (4), it is possible to both reduce pressure loss in the main stream caused by the boss part 12 and minimize increase in the ambient temperature around the fixing bolt 10.

### Third Embodiment

In the third embodiment, an expanded pathway groove is formed in the cooler cover, and the expanded pathway is formed by the expanded pathway groove and the cooler main unit.

The configuration will be described first. The cooling structure in the third embodiment is applied to an inverter device (an example of a power conversion device) of a motor generator mounted as a travel drive source or the like in a range-extended electric automobile (an example of an electrically driven vehicle), in the same manner as the first embodiment. Hereinbelow, the configuration of the third embodiment is described in two sections titled "Inverter Cooling Structure" and "Detailed Description of the Cooler."

### [Inverter Cooling Structure]

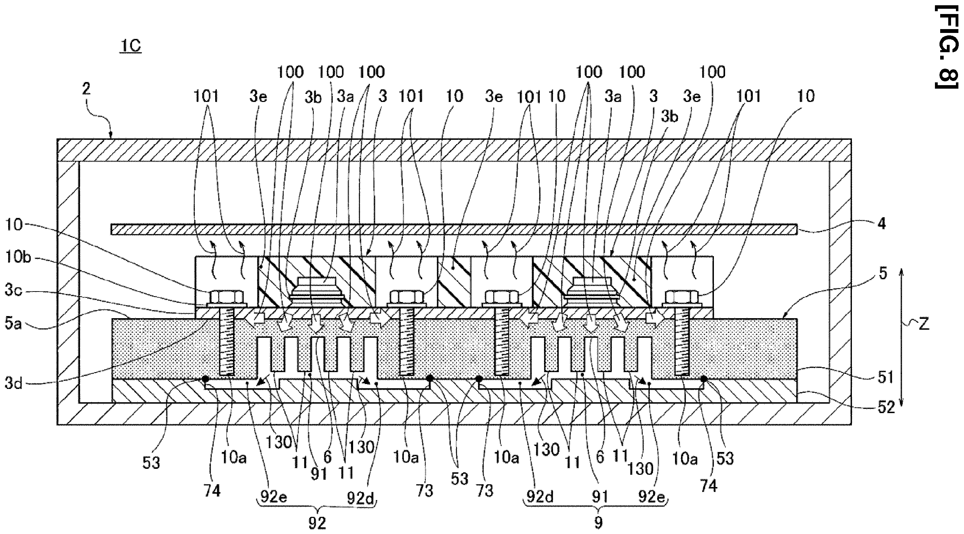

Figure 8 shows a cross-sectional view of the inverter cooling structure in the third embodiment. Hereinbelow, a detailed configuration of the cooling structure of an inverter 1C in the third embodiment is described based on Figure 8.

An internally threaded hole 13 is formed in the cooler main unit 51, and boss parts are not formed therein.

The fixing bolts 10 are inserted from a through-hole formed in the outer peripheral part of the heat spreader 3c and is fastened to the internally threaded hole 13. The configuration in "Inverter 1C Cooling Structure" is otherwise the same as the first embodiment, and the corresponding configuration is therefore denoted using the same symbols and a description thereof is omitted.

### [Detailed Description of the Cooler]

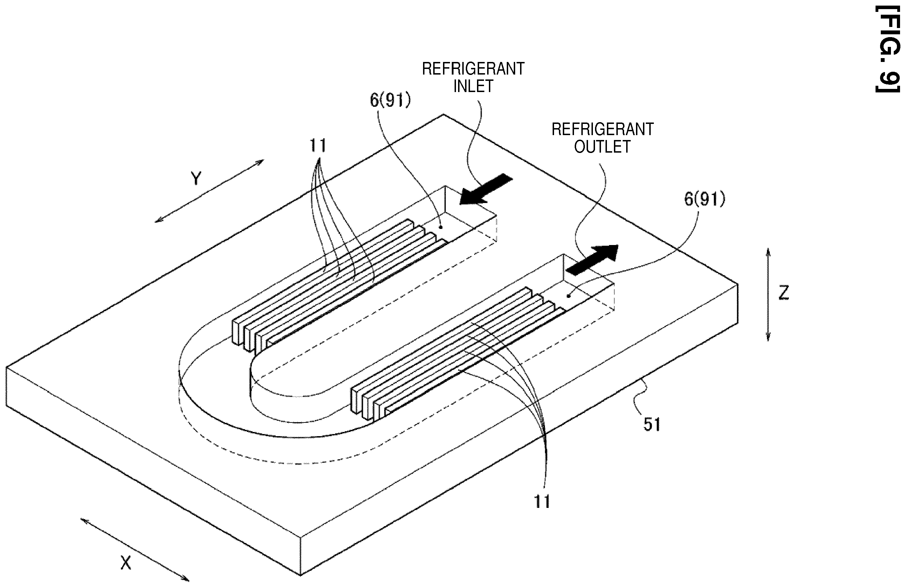

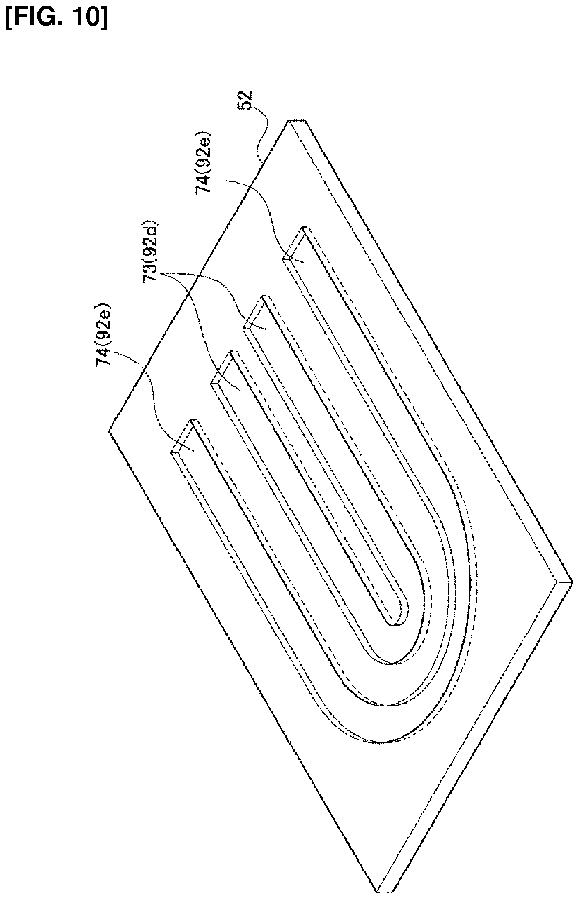

Figure 9 shows a perspective view of the reverse side of the cooler main unit in the third embodiment. Figure 10 shows a perspective view of the obverse side of the cooler cover in the third embodiment. Hereinbelow, a detailed configuration of the cooler in the third embodiment is described based on Figures 8 to 10. The obverse side of the cooler cover is the surface side of the power module 3 in Figure 8.

Two main pathway grooves 6 are formed in the cooler main unit 51.

Four expanded pathway grooves 7 are formed in the cooler cover 52. The expanded pathway grooves 7 are configured from two inner expanded pathway grooves 73 disposed on an inner side of the four expanded pathway grooves 7, and two outer expanded pathway grooves 74 disposed on an outer side of the four expanded pathway grooves 7. The expanded pathway grooves 7 are disposed in the X direction in the sequence of the outer expanded pathway groove 74, the inner expanded pathway groove 73, the inner expanded pathway groove 73, and the outer expanded pathway groove 74, as shown in Figure 10.

The two main pathway grooves 6 are partially in communication with each other, as shown in Figure 9. In other words, the two main pathway grooves 6 are in communication with each other so as to constitute a single groove. Also, two internally threaded holes are disposed on both sides of the single main pathway groove 6 in the X direction.

One main pathway groove 6 is in communication with a refrigerant inlet path (not shown) that allows refrigerant to flow from the exterior into the cooler 5 (see arrow). The other main pathway groove 6 is in communication with a refrigerant outlet path (not shown) that allows refrigerant to flow out from the cooler 5 to the exterior (see arrow).

A plurality of (e.g., four) fins 11 is formed in the main pathway grooves 6, as shown in Figure 9. The fins 11 are rectangular and extend in the Y direction of the main pathway grooves 6. The fins 11 are disposed at equidistant intervals in the X direction of the main pathway grooves 6. The height (Z direction) of the fins 11 is less than the height of the main pathway grooves 6, as shown in Figure 1.

The two inner expanded pathway grooves 73 are partially in communication with each other, as shown in Figure 10. In other words, the two inner expanded pathway grooves 73 are in communication with each other so as to constitute a single groove. The two outer expanded pathway grooves 74 are partially in communication with each other, as shown in Figure 10. In other words, the two outer expanded pathway grooves 74 are in communication with each other so as to constitute a single groove. Also, the inner expanded pathway grooves 73 and the outer expanded pathway grooves 74 are not in communication with each other.

When the cooler main unit 51 and the cooler cover 52 are joined together, the two main pathway grooves 6 and the four expanded pathway grooves 7 are in communication with each other, and a refrigerant channel 9 is formed between the cooler main unit 51 and the cooler cover 52, as shown in Figure 8. In other words, main pathways 91 and expanded pathways 92 are formed as the refrigerant channel 9.

The main pathways 91 are formed by the main pathway grooves 6 and the cooler cover 52. The expanded pathways 92 are configured from an inner expanded pathway 92d and an outer expanded pathway 92e. The inner expanded pathway 92d is formed by the inner expanded pathway grooves 73 and the cooler main unit 51. The outer expanded pathway 92e is formed by the outer expanded pathway grooves 74 and the cooler main unit 51. The inner expanded pathway 92d and the outer expanded pathway 92e are in communication with each other by way of the main pathways 91. Accordingly, the refrigerant channel 9 has the main pathways 91, the inner expanded pathway 92d, and the outer expanded pathway 92e.

When the power modules 3 are secured to the cooler main unit 51, the main pathways 91 are disposed opposite the power modules 3. Also, the expanded pathways 92 are pathways in which the channel has been expanded from the main pathways 91 to the bolt end 10a of the fixing bolts 10.

Next, the effect will be described.

The increase mechanism of the third embodiment exhibits the "Mechanism by which ambient temperature increases around the bolt" in the same manner as the first embodiment. Accordingly, the corresponding configuration is denoted using the same symbols in Figure 8 and a description thereof is omitted. The effect in the cooling structure of the inverter 1C of the third embodiment will be described hereinbelow in sections titled "Effect of refrigerant flow," "Basic effect of the inverter cooling structure," and "Characteristic effect of the inverter cooling structure."

### [Effect of Refrigerant Flow]

Regarding the refrigerant flow, the flow of refrigerant will be described below with reference to Figures 8 to 10. A configuration in which the cooler cover 52 of Figure 10 has been attached to the cooler main unit 51 of Figure 9 will be described. Accordingly, the main pathway grooves 6 serve as the main pathway 91, and therefore, the symbol for the pathway will be noted in parentheses following the symbol in Figure 9. The inner expanded pathway groove 73 serves as the inner expanded pathway 92d, and the outer expanded pathway groove 74 serves as the outer expanded pathway 92e, and therefore, the symbol for each pathway will be noted in parentheses following each symbol in Figure 10.

Refrigerant flows from the exterior to the refrigerant inlet path. Next, the refrigerant that has flowed in from the refrigerant inlet path flows to one end of one main pathway 91 (see arrow). When this occurs, the refrigerant that has flowed from the refrigerant inlet path flows to one inner expanded pathways 92d and one outer expanded pathways 92e by way of the one main pathway 91, as indicated by an arrow 130 in Figure 8.

Next, the refrigerant that has flowed into one main pathway 91 flows from the one main pathway 91 into the other main pathway 91. Similarly, the refrigerant that has flowed into one inner expanded pathway 92d flows from the one inner expanded pathway 92d to the other inner expanded pathway 92d. Also, the refrigerant that has flowed into one outer expanded pathway 92e flows from the one outer expanded pathway 92e to the other outer expanded pathway 92e.

At this time, the refrigerant flowing through the one main pathway 91 flows between the fins 11 and the like. Accordingly, the heat emitted by the semiconductor element 3a is dissipated by the fins 11 by heat exchange. In other words, the power module 3 is cooled.

Also, the refrigerant flowing through the one inner expanded pathway 92d and the one outer expanded pathway 92e flows below the bolt end 10a. Accordingly, the bolt end 10a of the fixing bolts 10 is cooled by the refrigerant. The fixing bolts 10 are thereby cooled.

The refrigerant that has flowed into the other main pathway 91, the other inner expanded pathway 92d, and the other outer expanded pathway 92e flows out from the other main pathway 91 to the refrigerant outlet path (see arrow). That is to say, the refrigerant flowing through the other inner expanded pathway 92d and the other outer expanded pathway 92e flows out to the refrigerant outlet path by way of the other main pathway 91. In other words, the refrigerant flows out to the exterior. Also, the refrigerant flowing through the other main pathway 91 flows between the fins 11 and the like in the same manner as the refrigerant flowing through the one main pathway 91. Furthermore, the refrigerant flowing through the other inner expanded pathway 92d and the other outer expanded pathway 92e flows below the bolt end 10a in the same manner as the refrigerant flowing through the one inner expanded pathway 92d and the other outer expanded pathway 92e. Accordingly, the power modules 3 and the fixing bolts 10 are cooled by the refrigerant in the same manner as described above.

### [Basic Effect of the Inverter Cooling Structure]

In the third embodiment, the cooling structure of the inverter 1A has, as the refrigerant channel 9, main pathways 91 disposed opposite the power modules 3, and expanded pathways 92 having a channel that is expanded from the main pathways 91 to the bolt end 10a of the fixing bolts 10, in the same manner as the first embodiment. As a result, an increase of the ambient temperature around the fixing bolts 10 is minimized.

In the third embodiment, the main pathway grooves 6 are formed in the cooler main unit 51, and the expanded pathway grooves 7 in communication with the main pathway grooves 6 are formed in the cooler cover 52. When the cooler main unit 51 and the cooler cover 52 are joined together, the main pathways 91 are formed by the main pathway grooves 6, between the cooler main unit 51 and the cooler cover 52. Also, when the cooler main unit 51 and the cooler cover 52 are joined together, the expanded pathways 92 are formed by the expanded pathway grooves 7, between the cooler main unit 51 and the cooler cover 52. Therefore, the main pathways 91 and the expanded pathways 92 serving as the refrigerant channel 9 can be readily formed merely by forming the pathway grooves 6, 7 in the cooler main unit 51 and the cooler cover 52.

### [Characteristic Effect of the Inverter Cooling Structure]

In the third embodiment, the main pathway grooves 6 are formed in the cooler main unit 51. The expanded pathway grooves 7 are formed in the cooler cover 52. When the cooler main unit 51 and the cooler cover 52 are joined together, the main pathway grooves 6 and the expanded pathway grooves 7 are in communication with each other, the main pathways 91 are formed by the main pathway grooves 6 and the cooler cover 52, and the expanded pathways 92 are formed by the expanded pathway grooves 7 and the cooler main unit 51. In other words, even when a thickness (thickness in the Z direction, thickness in the height direction) of the cooler main unit 51 is low due to space constraints or the like and the expanded pathway grooves 7 cannot be formed in the cooler main unit 51, the expanded pathway grooves 7 can be formed in the cooler cover 52. Accordingly, the bolt end 10a of the fixing bolts 10 is cooled by the refrigerant flowing through the expanded pathway 92, and efficiency of cooling the fixing bolts 10 is increased. Accordingly, an increase in the heat of the fixing bolts 10 is minimized even when the fixing bolts 10 absorb the heat in the semiconductor element 3a. Also, the overall thickness of the cooler 5 in the Z direction can be made less than that in the first embodiment and the second embodiment. Therefore, even when the expanded pathway grooves 7 cannot be formed in the cooler main unit 51, forming the expanded pathway grooves 7 in the cooler cover 52 allows an increase in the ambient temperature around the fixing bolts 10 to be minimized.

In addition, the main pathways 91 and the expanded pathways 92 serving as the refrigerant channel 9 are formed between the cooler main unit 51 and the cooler cover 52 merely by joining a cooler cover 52 in which the expanded pathway grooves 7 are formed to an existing cooler main unit 51 in which the main pathway grooves 6 are formed. Accordingly, the existing cooler main unit 51 can be used.

Next, the effect will be described. The effects described in (1) and (3) of the first embodiment are obtained in a manner similar to the first embodiment by the cooling structure of the inverter 1C in the third embodiment. Also, the effect in (8) below can be obtained by the cooling structure of the inverter 1C in the third embodiment.

(8) The main pathway grooves 6 are formed in the cooler main unit 51. The expanded pathway grooves 7 are formed in the cooler cover 52. When the cooler main unit 51 and the cooler cover 52 are joined together, the main pathway grooves 6 and the expanded pathway grooves 7 are in communication with each other, the main pathway 91 is formed by the main pathway grooves 6 and the cooler cover 52, and the expanded pathway 92 is formed by the expanded pathway grooves 7 and the cooler main unit 51. Accordingly, in addition to the effects of (1) and (3), even when expanded pathway grooves 7 cannot be formed in the cooler main unit 51, forming the expanded pathway grooves 7 in the cooler cover 52 makes it possible to suppress an increase in the ambient temperature around the fixing bolts 10.

The cooling structures of a power conversion device of the present disclosure have been described above on the basis of the first to third embodiments. However, the specific configuration is not limited to these embodiments, and design changes, additions, and the like are permitted within the scope of the invention set forth in the claims.

In the first embodiment, an example was presented in which partitions 8 are formed in the cooler main unit 51. However, the partitions 8 are not required. In this case, the expanded pathway serves as a pathway in which the entire main pathway has been expanded in the X direction.

In the second embodiment, an example was presented in which the boss parts 12 are disposed in a position away from the side wall 7a of the expanded pathway grooves 7. However, the boss parts may be disposed in a position adjacent to the side wall of the expanded pathway groove. In this case, the refrigerant that flows from the main pathways into the expanded pathways flows around the boss parts. Therefore, even when the boss parts are disposed in this manner, the fixing bolts are cooled in the same manner as in the second embodiment.

In the first and second embodiments, examples were presented in which the boss parts 12 to which the fixing bolts 10 are fastened are formed in the expanded pathway grooves 7. However, it is also possible to omit the boss parts and form only an internally threaded hole in the cooler main unit, in the manner of the third embodiment.

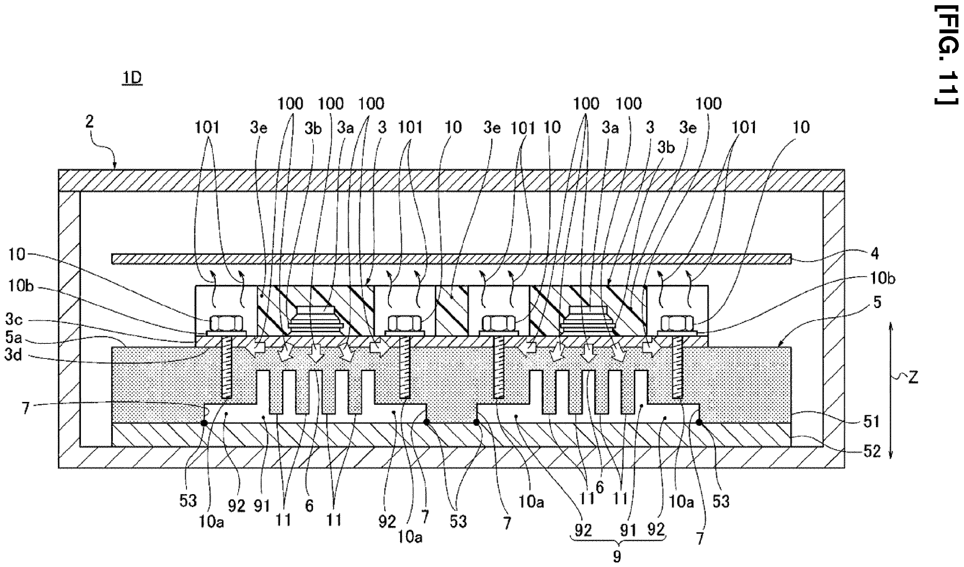

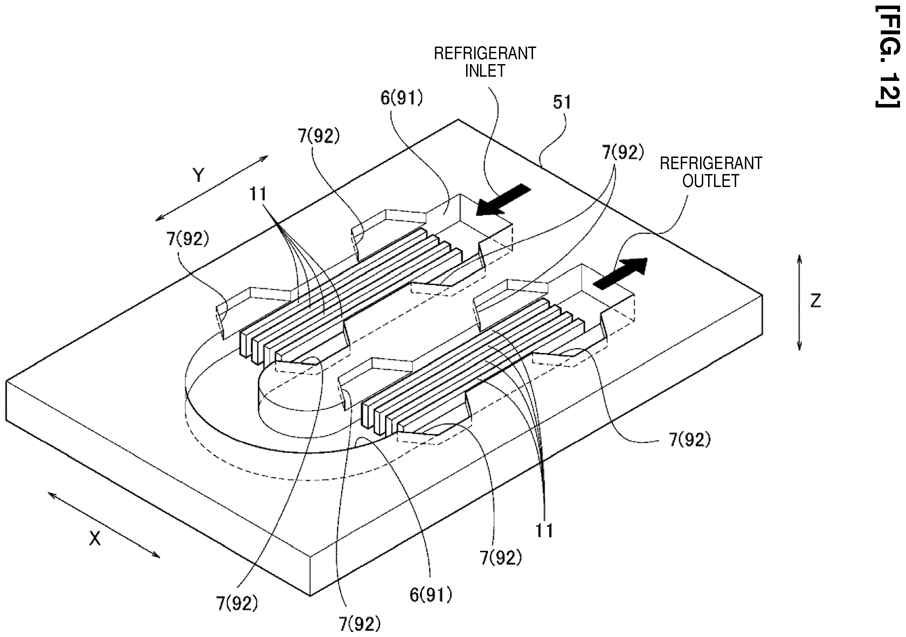

In the first and second embodiments, examples were presented in which the height (depth) of the expanded pathway grooves 7 is made to be the same as the height (depth) of the main pathway grooves 6. However, the height (depth) of the expanded pathway grooves 7 may be less than the height (depth) of the main pathway grooves 6. That is to say, a portion of the expanded pathway grooves 7 can be expanded with respect to the height direction (Z direction) of the main pathway grooves 6. For example, a configuration can be used in which a portion of the expanded pathway grooves 7 is expanded with respect to the height direction of the main pathway grooves 6, and furthermore the boss parts 12 are not formed in the expanded pathway grooves 7, as shown in Figures 11 and 12, as a modified embodiment (inverter 1D) of the inverter cooling structure of the present disclosure. Even with such a configuration, the effects described in (1), (3), and (4) of the first embodiment are obtained. In addition, a portion of the expanded pathway grooves 7 is expanded with respect to the height direction of the main pathway grooves 6, and pressure loss in the refrigerant channel 9 can therefore be reduced more greatly than across the entirety of the main pathway grooves 6 in the height direction. The configuration is otherwise the same as "Inverter Cooling Structure" of the embodiments, and the corresponding configuration is denoted using the same symbols in Figures 11 and 12 and a description thereof is omitted.

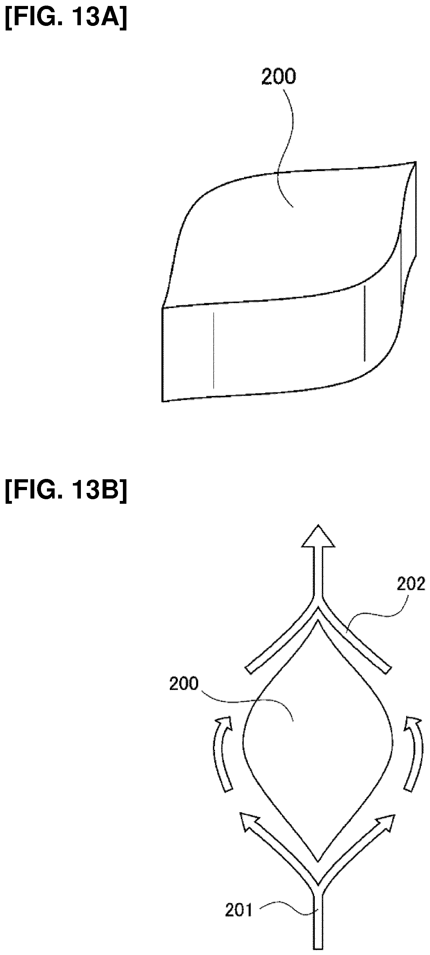

In the first embodiment, an example was presented in which the edge of the boss parts 12 is formed in a filleted shape. However, there is no limitation thereto. For example, the shape of the boss parts 200 can be a convex shape around which a branching flow (arrow 201) and a merging flow (arrow 202) of the refrigerant are smooth with respect to the direction of flow of the refrigerant flowing through the expanded pathways, as shown in Figures 13A and 13B. In other words, when the refrigerant flowing through the expanded pathways collides with the boss parts, the shape of the boss parts is a convex shape, and pressure loss that occurs in a collision can therefore be more greatly reduced than when the shape of the boss parts is not a convex shape. Therefore, pressure loss in the expanded pathways 92 can be reduced.

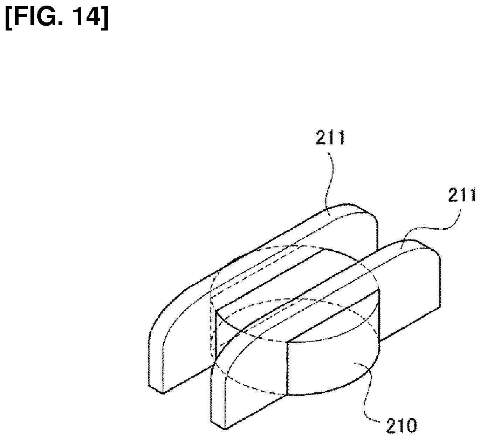

Also, for example, boss part fins 211 can be provided to a boss part 210 in the direction of flow of the refrigerant flowing through the expanded pathway, as shown in Figure 14. The flow of refrigerant that has flowed to the boss part can thereby be stabilized. Also, the heat emitted by fixing bolt is dissipated by heat exchange by the boss part fins 211. In other words, the boss part fins 211 serve a cooling function, whereby performance for cooling the fixing bolt can be improved. Consequently, an increase of the ambient temperature around the fixing bolt is more greatly minimized.

Furthermore, in the case of the boss parts 12 of the second embodiment, boss part fins can be provided around the boss parts 12 in the direction of flow of the refrigerant flowing through the expanded pathway. Even configured in this manner, the boss part fins serve a cooling function, whereby performance for cooling the fixing bolts can be improved in the same manner as described above. Consequently, an increase of the ambient temperature around the fixing bolts is more greatly minimized.

In the first to third embodiments, examples were presented in which the cooling structure of a power conversion device of the present disclosure is applied to configuration in which the cooling scheme of the power modules 3 is indirect cooling (indirect cooling structure). However, there is no limitation thereto. For example, the cooling structure of a power conversion device of the present disclosure can also be applied a direct-cooling structure and a cooler-integrated structure.

In the first to third embodiments, examples were presented in which the cooling structure of a power conversion device of the present disclosure is applied to two power modules 3. However, the cooling structure of a power conversion device of the present disclosure can also be applied a single power module.

In the first to third embodiments, examples were presented in which the power converter is a power module 3. However, other than a power module, for example, a component such as a smoothing capacitor, a discharge resistor, and the like, or a combination of two or more such components can be used as a power converter.

In the first to third embodiments, examples were presented in which the cooling structure of a power conversion device of the present disclosure is applied an inverter used as an AC/DC conversion device of a motor generator. However, the cooling structure of the present disclosure can also be applied to various power conversion devices other than an inverter for converting one or more of voltage, current, frequency, phase, phase number, waveform, or other electrical characteristic using a power converter while minimizing substantial power loss.

## Claims

1. A cooling structure of a power conversion device **characterized in** comprising:
a power converter;
a cooler in which a refrigerant channel is formed; and
a fixing bolt that secures the power converter to the cooler in a state in which the power converter and the refrigerant channel are disposed opposite each other;
the refrigerant channel having a main pathway disposed opposite the power converter, and an expanded pathway in which a channel is expanded from the main pathway to a bolt end of the fixing bolt.

2. The cooling structure of a power conversion device according to claim 1, **characterized in that**
a boss part to which the fixing bolt is fastened is formed in the cooler, and
the boss part is disposed in the expanded pathway.

3. The cooling structure of a power conversion device according to claim 1 or 2, **characterized in that**
the cooler is configured from a cooler main unit and a cooler cover,
a main pathway groove and an expanded pathway groove are formed in the cooler main unit and/or the cooler cover, and
when the cooler main unit and the cooler cover are joined together, the main pathway is formed between the cooler main unit and the cooler cover by the main pathway groove, and the expanded pathway is formed between the cooler main unit and the cooler cover by the expanded pathway groove.

4. The cooling structure of a power conversion device according to claim 3, **characterized in that**
the main pathway groove and the expanded pathway groove in communication with the main pathway groove are formed in the cooler main unit, and
when the cooler main unit and the cooler cover are joined together, the main pathway is formed by the main pathway groove and the cooler cover, and the expanded pathway is formed by the expanded pathway groove and the cooler cover.

5. The cooling structure of a power conversion device according to claim 3, **characterized in that**
the main pathway groove is formed in the cooler main unit,
the expanded pathway groove is formed in the cooler cover, and
when the cooler main unit and the cooler cover are joined together, the main pathway groove and the expanded pathway groove are in communication with each other, the main pathway is formed by the main pathway groove and the cooler cover, and the expanded pathway is formed by the expanded pathway groove and the cooler main unit.

6. The cooling structure of a power conversion device according to any one of claims 1 to 5, **characterized in that**
the main pathway and the expanded pathway are disposed in adjacent positions with partitions interposed therebetween, and
the expanded pathway is a first expanded pathway expanded to an inlet side where refrigerant flowing through the refrigerant channel flows into the main pathway and to an outlet side where the refrigerant flows out from the main pathway.

7. The cooling structure of a power conversion device according to any one of claims 2 to 5, **characterized in that**
the expanded pathway is a second expanded pathway where a part of the main pathway has been expanded, and
the boss part is disposed in the second expanded pathway such that a bypass pathway that bypasses the boss part is formed.

8. The cooling structure of a power conversion device according to any one of claims 2 to 7, **characterized in that**
an edge of the boss part is formed in a filleted shape.

9. The cooling structure of a power conversion device according to any one of claims 2 to 7, **characterized in that**
the shape of the boss part is a convex shape in which a branching flow and a merging flow of the refrigerant are smooth with respect to a direction of flow of the refrigerant flowing through the expanded pathway.

10. The cooling structure of a power conversion device according to any one of claims 2 to 7, **characterized in that**
fins are provided to the boss part in a direction of flow of the refrigerant flowing through the expanded pathway.
